Europäisches Patentamt

European Patent Office

Office européen des brevets

(19)

(11) Veröffentlichungsnummer: **0 238 017**
A2

(12) **EUROPÄISCHE PATENTANMELDUNG**

(21) Anmeldenummer: 87103777.6

(22) Anmeldetag: 16.03.87

(51) Int. Cl.³: **H 01 R 25/14**

(30) Priorität: 21.03.86 DE 3609660

(43) Veröffentlichungstag der Anmeldung:
23.09.87 Patentblatt 87/39

(84) Benannte Vertragsstaaten:
DE FR GB IT

(71) Anmelder: Bartel, Bernhard
Strassbergerstrasse 10
8000 München 40(DE)

(72) Erfinder: Bartel, Bernhard
Strassbergerstrasse 10
8000 München 40(DE)

(74) Vertreter: Patentanwälte Kirschner & Grosse
Herzog-Wilhelm-Strasse 17
D-8000 München 2(DE)

(54) Elektrische Einrichtung mit mindestens einer auf einer Fläche lösbar angeordneten elektrischen Verbrauchereinheit.

(57) Die Erfindung bezieht sich auf eine elektrische Einrichtung mit mindestens einem auf einer mit Leiterbahnen (L) versehenen Fläche (F) magnetisch haftenden, elektrischen Verbrauchereinheit (E). Die Verbrauchereinheit (E) enthält einen elektrischen Verbraucher (G), der auf einem Sockel (S) angeordnet ist. Der Sockel (S) ist mit mindestens einem Magneten (M) versehen und an der Unterseite des Sockels (S) sind Kontakte (K) angeordnet, über die von einer Spannungsquelle (SP) abgegebene elektrische Energie über die Leiterbahnen (L) dem Verbraucher (G) zugeführt wird. Die Kontakte (K) sind derart angeordnet, daß bei einer Verschiebung und/oder Drehung der Verbrauchereinheit (E) der Verbraucher (G) ein- und ausschaltbar ist. Der Verbraucher (G) ist als Leuchtköper ausgebildet und die Spannungsquelle ist eine Gleichspannungs- oder Wechselspannungs-Niederspannungsquelle.

Fig.1

EP 0 238 017 A2

**KIRSCHNER & GROSSE**

Kirschner & Grosse, Herzog-Wilhelm-Str.17, 8 München 2

**PATENTANWÄLTE**

ZUGELASSENE VERTRETER
BEIM EUROPÄISCHEN PATENTAMT
EUROPEAN PATENT ATTORNEYS

KLAUS D. KIRSCHNER, DIPL.-PHYSIKER
WOLFGANG GROSSE, DIPL.-INGENIEUR

D-8000 MÜNCHEN 2
HERZOG-WILHELM-STRASSE 17

☎ 089 / 26 40 48
TELEX 5-212 570 PAKID
FAX 089-26 83 94 GROUP II & III

Bernhard BARTEL

München

13.03.1987
K/la

B 7014.4 EP

---

Elektrische Einrichtung mit mindestens einer auf einer Fläche
lösbar angeordneten elektrischen Verbrauchereinheit

---

Die Erfindung bezieht sich auf eine elektrische Einrichtung
mit mindestens einer auf einer Fläche lösbar angeordneten
elektrischen Verbrauchereinheit gemäß dem Oberbegriff des
Patentanspruchs 1.

Eine derartige elektrische Einrichtung ist beispielsweise
aus dem DE-GM 1 892 432 bekannt. Dort ist ein Lehr- und Demonstrationsmittel für elektrische Schaltungen beschrieben,
bei dem verschiedene Bauteile, wie Widerstände, Glühlampen,
Kondensatoren und Verbindungsleitungen in Bausteinen angeordnet sind. Diese Bausteine sind mittels Haftmagneten auf
einer Fläche mit einer ferromagnetischen Schicht befestigbar.
Die elektrische Energie wird dabei den Bauteilen über Verbindungsstecker zugeführt, die in seitlich an der Wand vorgesehenen Buchsen einsetzbar sind.

Aus der DE-OS 31 51 996 ist eine Niederspannungslampe bekannt, die aus einer Reflektorhalbkugel, einem Sockel und
Stromzuführungsschienen besteht. Die Reflektorhalbkugel
ist mit einem Magneten an dem Sockel befestigt, um die Reflektorhalbkugel gegenüber dem Sockel verstellen zu können.

Da der Sockel die Schienen umgibt, kann die Lampe nur auf den Schienen hin- und herbewegt werden.

Aus Technischer Runschau 1974, Band 66, Heft 38, Seiten 17 bis 21, "Elektronikbaukästen und Experimentiersysteme" ist eine Grundplatte mit Leitern bekannt, die Kontaktsockel aufweisen, in die Verbraucherbausteine mit entsprechenden Kunststoffstiften eingesteckt werden können. Daher können die Verbraucher nur an den Stellen mit den entsprechenden Leitern in der Grundplatte verbunden werden, an denen auch zu den Steckerstiften passende Sockel in den Leitern vorgesehen sind.

Bei dem Stand der Technik ist es demnach nicht möglich, die Verbraucher an beliebigen Stellen einer Fläche anzubringen.

Der Erfindung liegt daher die Aufgabe zugrunde, eine elektrische Einrichtung anzugeben, mittels der die elektrischen Verbrauchereinheiten auf einfache Weise an einer beliebigen Stelle einer Fläche angebracht werden können, ohne daß besondere Verbindungsleitungen für eine Versorgung mit elektrischer Energie erforderlich sind.

Erfindungsgemäß wird die Aufgabe bei der elektrischen Einrichtung der eingangs genannten Art durch die im kennzeichnenden Teil des Patentanspruchs 1 angegebenen Merkmale gelöst.

Die elektrische Einrichtung gemäß der Erfindung verbindet die Vorteile der magnetischen Haftung einer elektrischen Verbrauchereinheit an einer beliebigen Stelle einer Fläche mit den Vorteilen einer Versorgung mit elektrischer Energie über Leiterbahnen. Damit sind bei der elektrischen Einrichtung gemäß der Erfindung keine mechanischen Befestigungsmittel und keine zusätzlichen elektrischen Verbindungsleitungen zu den einzelnen elektrischen Verbrauchereinheiten erforderlich. Hinzu kommt, daß durch einfache Veränderung der Position der elektrischen Verbrauchereinheit der Verbraucher ein- und ausgeschaltet werden kann. Es wird die Möglichkeit geschaffen, Tafeln mit beliebig vielen Verbrauchern, beispielsweise Lichtbänder mit beliebig vielen Leuchtkörpern an beliebigen Stellen der Fläche anzubringen. Dies gilt sowohl für ebene als auch für gekrümmte Flächen.

0238017

An dem Sockel der Verbrauchereinheit ist mindestens ein Magnet vorgesehen, der die Verbrauchereinheit gegen die Tafel drückt. Es erweist sich als günstig, zwei Magnete vorzusehen, die gleichzeitig als elektrische Kontakte mit verwendet werden können. Auch ist es möglich, sternförmig vier Magnete anzuordnen, wovon zwei gleichzeitig als Kontakte ausgebildet sind.

Die Leiterbahnen können streifenförmig, drahtförmig oder schienenförmig ausgebildet sein. Dabei können sie in eine Isolierschicht eingebettet sein. Für die Befestigung sind zusätzliche ferromagnetische Schichten in der Fläche nicht erforderlich, wenn die Leiterbahnen bereits ein ferromagnetisches Material enthalten. Es ist jedoch auch möglich, durch mindestens eine Isolierschicht getrennt von den Leiterbahnen ferromagnetische Schichten vorzusehen. Um die Stromdichte auf den ferromagnetischen Leiterbahnen zu vermindern ist es günstig, wenn in Kontakt mit diesen Leiterbahnen weitere Leiterbahnen aus nicht ferromagnetischem Material, beispielsweise aus Kupfer vorgesehen sind.

Aus Sicherheitsgründen ist es günstig, wenn die Spannungsquelle als Niederspannungsquelle ausgebildet ist. Sie kann dabei als Gleichspannungs-Niederspannungsquelle oder als Wechselspannungs-Niederspannungsquelle ausgebildet sein.

Als elektrische Verbraucher können Leuchtkörper, wie beispielsweise Glühlampen oder mit Reflektoren versehene Scheinwerfer vorgesehen sein. Es ist auch möglich, andere elektrische Verbraucher, wie beispielsweise einen Ventilator oder eine Steckdose, für einen entfernt anschließbaren Verbraucher vorzusehen.

Die Fläche mit den Leiterbahnen kann als ebene Fläche oder als gekrümmte Fläche ausgebildet sein. Sie kann plattenförmig, folienartig oder bandförmig ausgebildet sein.

Für die Verbindung der Leiterbahnen mit der Spannungsquelle können an den Enden oder in vorgegebenen Abständen Verbindungsleitungen vorgesehen werden, die permanent befestigt oder aufsteckbar ausgebildet sind.

Ausführungsbeispiele der Erfindung werden im folgenden anhand von Zeichnungen näher erläutert. Es zeigen:

Fig. 1    ein Schnittbild einer elektrischen Verbrauchereinheit und einer zugehörigen Fläche,

Fig. 2    eine schematische Draufsicht auf einen Ausschnitt der elektrischen Einrichtung,

Fig. 3    bis 7 Schnittbilder von verschiedenen mit Leiterbahnen versehenen Flächen,

Fig. 8    ein weiteres Ausführungsbeispiel einer elektrischen Verbrauchereinheit.

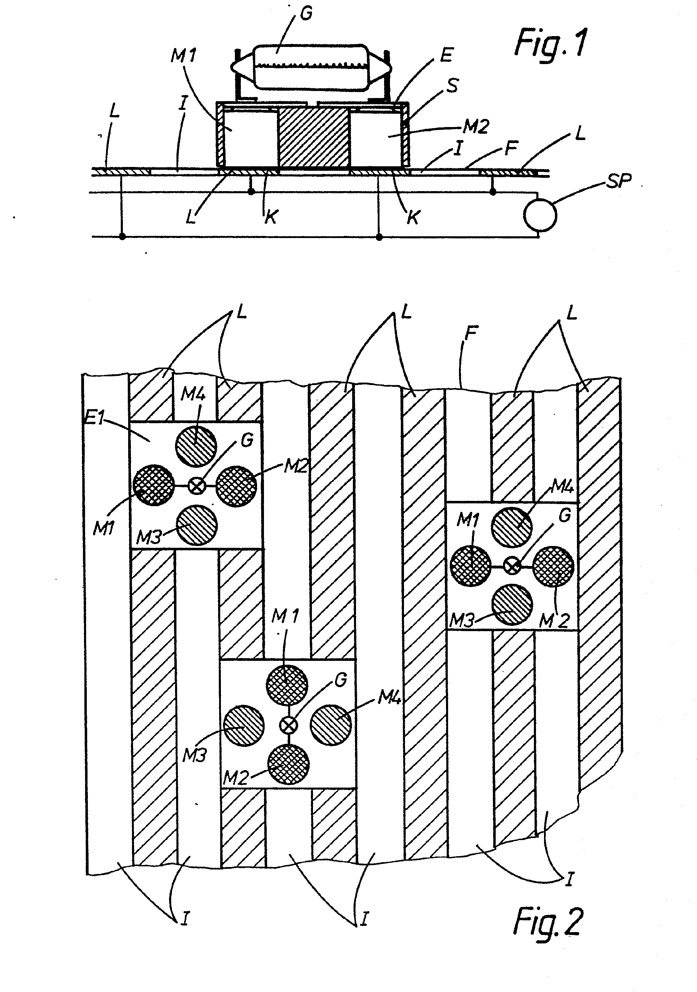

Bei der in Fig. 1 dargestellten elektrischen Einrichtung sind auf einer Fläche F, die plattenförmig, folienartig oder bandförmig ausgebildet ist, mehrere, im wesentlichen parallele Leiterbahnen L angeordnet, von denen die geradzahligen und die ungeradzahligen jeweils miteinander und mit den Anschlüssen einer Spannungsquelle SP verbunden sind. Die Spannungsquelle SP ist aus Sicherheitsgründen vorzugsweise als Niederspannungsquelle ausgebildet. Sie kann als Gleichspannungs- oder als Wechselspannungs-Niederspannungsquelle mit einer Spannung von beispielsweise 6 Volt oder 12 Volt ausgebildet sein. Jeweils einander benachbarte Leiterbahnen sind voneinander elektrisch isoliert, wobei die Zwischenräume durch Isolierschichten I ausgefüllt sein können.

Auf der Fläche F ist mindestens eine mit einem elektrischen Verbraucher G versehene elektrische Verbrauchereinheit E frei positionierbar angeordnet. Die Verbrauchereinheit E enthält einen Sockel S, an dessen Unterseite mindestens zwei Kontakte K vorgesehen sind, über die dem Verbraucher G, beispielsweise einem als Glühlampe G ausgebildeten Leuchtkörper elektrische Energie zugeführt werden kann. Weiterhin ist in dem Sockel S mindestens ein Magnet vorgesehen, durch dessen Magnetkraft die Verbrauchereinheit E gegen die Fläche F gedrückt wird. Wenn zwei Magnete M1 und M2 vorgesehen sind, können diese oder deren Umfassung gleichzeitig als Kontakte K ausgebildet sein. Es ist auch möglich, vier Magnete vorzusehen, von denen dann beispielsweise zwei mit den Kontakten K versehen sind und zwei isoliert sind. Das Festhalten an der Fläche erfolgt dadurch, daß die Leiterbahnen L ferromagnetisch ausgebildet sind oder daß in der Fläche F mindestens eine ferromagnetische Schicht vorgesehen ist.

Wenn die Verbrauchereinheit E derart auf die Fläche F aufgesetzt wird, daß die Kontakte K die Leiterbahnen L berühren, wird von der Spannungsquelle SP elektrische Energie dem Verbraucher G auf dem Sockel S zugeführt, so daß beispielsweise der als Glühlampe ausgebildete Verbraucher G leuchtet. Wenn jedoch die Verbrauchereinheit E um 90° gedreht wird oder derart verschoben wird, daß die Kontakte K nicht die entsprechenden Leiterbahnen L berühren, wird dem Verbraucher G keine elektrische Energie mehr zugeführt, so daß er nicht eingeschaltet ist. Durch Drehung und/oder Verschieben der Verbrauchereinheit E kann damit der Verbraucher G ein- und ausgeschaltet werden.

Bei der in Fig. 2 dargestellten elektrischen Einrichtung sind auf der Fläche F mit den Leiterbahnen L drei Verbrauchereinheiten E1 bis E3 angeordnet, von denen jeweils nur der untere Bereich und der Verbraucher G schematisch dargestellt ist. Jede Verbrauchereinheit E1 bis E3 weist vier Magnete M1 bis M4 auf, die an den Ecken eines gedachten Quadrates sternförmig angeordnet sind. Die Magnete M1 und M2 sind einerseits mit Kontakten K versehen und andererseits mit dem Verbraucher G elektrisch verbunden. Die Magnete M3 und M4 sind dagegen isoliert angeordnet.

Die Verbrauchereinheit E1 ist derart auf der Fläche F angeordnet, daß die Magnete M1 und M2 auf den Leiterbahnen L aufgesetzt sind, während die Magnete M3 und M4 auf der Isolierschicht I dazwischen aufgesetzt sind. Da die Magnete M1 und M2 Kontakte K aufweisen, wird elektrische Energie von der Spannungsquelle SP dem schematisch dargestellten Verbraucher G zugeführt, so daß dieser eingeschaltet ist.

Zum Ausschalten des Verbrauchers G kann die Verbrauchereinheit E1 in eine der Verbrauchereinheit E2 entsprechende Stellung verschoben werden, in der die isolierten Magnete M3 und M4 auf die Leiterbahn L aufgesetzt sind, während die Magnete M1 und M2 auf der Isolierschicht I zu liegen kommen.

Das Ausschalten des Verbrauchers G kann auch dadurch erfolgen, daß die Verbrauchereinheit E1 um 90$^{\circ}$ um eine Achse senkrecht zur Fläche F gedreht wird. Diese Stellung entspricht der Stellung der Verbrauchereinheit E3, bei der die Magnete M1 und M2 auf der Isolierschicht I oder derselben Leiterbahn L zu liegen kommen.

Durch Verschieben und/oder Drehung kann somit der elektrische Verbraucher G der Verbrauchereinheit E1 bis E3 ein- und ausgeschaltet werden, so daß ein Schalter nicht erforderlich ist. Durch eine Vielzahl von Leiterbahnen L auf der Fläche F können die Verbrauchereinheiten E auch freizügig auf der Fläche F angeordnet werden und durch Drehung und/oder Verschiebung jeweils ein- und ausgeschaltet werden.

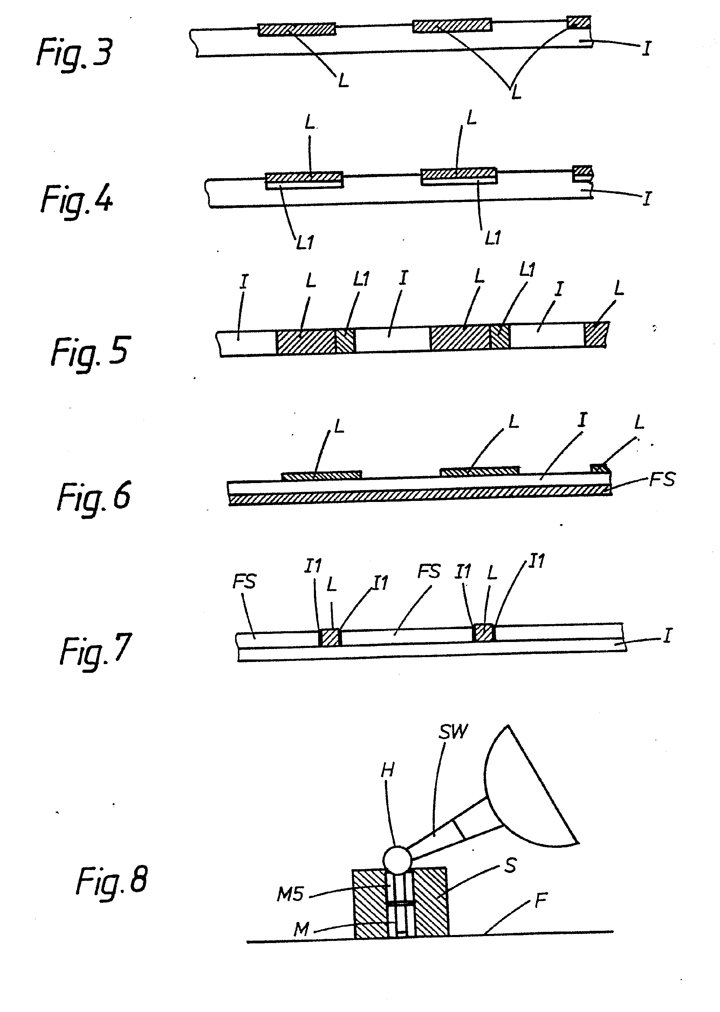

Bei der in Fig. 3 dargestellten Fläche F sind die Leiterbahnen L in einer Isolierschicht I angeordnet. Die Leiterbahnen L sind in diesem Fall mit einem ferromagnetischen Material versehen und dienen sowohl zum Zuführen der elektrischen Energie als auch zum Befestigen der Verbrauchereinheit E.

Bei der in Fig. 4 dargestellten Ausführungsform der Fläche F sind die Leiterbahnen L ebenfalls in der Isolierschicht eingebettet. Unterhalb der Leiterbahnen L aus ferromagnetischem Material sind jedoch zur Verminderung des elektrischen Widerstands in den Leiterbahnen L weitere Leiterbahnen L1 vorgesehen, die aus elektrisch leitendem Material, jedoch nicht ferromagnetischem Material, wie beispielsweise Kupfer bestehen.

Die Fig. 5 zeigt eine ähnliche Fläche F, bei der jedoch die weiteren Leiterbahnen L1 nicht unterhalb der Leiterbahn L, sondern neben diesen angeordnet sind.

Die Fig. 6 zeigt eine Fläche F, die eine ferromagnetische Schicht FS aufweist, über der eine Isolierschicht I angeordnet ist, auf oder in der die Leiterbahnen L angeordnet sind.

Schließlich zeigt die Fig. 7 noch draht- oder schienenförmige Leiterbahnen L, die auf eine Isolierschicht I angebracht sind und zwischen denen durch Isolierschichten I1 getrennte ferromagnetische Schichten FS für die Magnete M angebracht sind.

Die Flächen F können in allen Fällen als ebene oder gekrümmte Platten oder Folien ausgebildet sein, wobei insbesondere die Folien auch bandförmig ausgebildet sein können, so daß diese beispielsweise bei Bedarf von einer Rolle abgeschnitten werden können. In diesem Fall können die Flächen ähnlich wie eine Tapete an einer Wand oder einer Decke angebracht werden.

Für die Zuführung der elektrischen Energie an die Leiterbahnen L können an den Enden der Flächen befestigbare, beispielsweise aufsteckbare Stromschienen vorgesehen werden. Es ist auch möglich, die elektrische Energie in vorgegebenen Abständen innerhalb der Fläche einzuspeisen.

Als elektrische Verbraucher G können auf den Verbrauchereinheiten auch Scheinwerfer vorgesehen werden, wie dies in Fig. 8 dargestellt ist. Der Scheinwerfer SW kann dabei ebenfalls durch mindestens einen Magneten M5 festgehalten sein und die elektrische Energie kann über Kontaktflächen an einer Halterung A zugeführt werden.

Als elektrische Verbraucher können auch von Leuchtkörpern verschiedene elektrische Geräte, wie beispielsweise ein elektrischer Ventilator vorgesehen werden. Es ist auch möglich, eine Verbrauchereinheit E als Steckdose auszubilden und mit Buchsen zu versehen. In diesem Fall kann die Verbrauchereinheit E sehr leicht an verschiedenen Stellen der Fläche F angeordnet werden und über einen eingesteckten Stecker einen entfernt angeordneten elektrischen Verbraucher mit elektrischer Energie versorgen.

Patentansprüche

1. Elektrische Einrichtung mit mindestens einer auf einer Fläche lösbar angeordneten elektrischen Verbrauchereinheit, wobei die Verbrauchereinheit einen Sockel aufweist, an dessen Unterseite mindestens ein Magnet zum lösbaren Befestigen der Verbrauchereinheit an der Fläche vorgesehen ist, und wobei die Verbrauchereinheit Kontakte aufweist, über die einem an der Verbrauchereinheit angeordneten elektrischen Verbraucher elektrische Energie zuführbar ist, dadurch g e k e n n z e i c h n e t, daß die Fläche (F) eine Mehrzahl von im wesentlichen parallelen, voneinander isolierten Leiterbahnen (L) aufweist, von denen jeweils die geradzahligen und die ungeradzahligen miteinander und mit den Anschlüssen einer Niederspannungsquelle verbunden sind, daß die Kontakte (K) an der Unterseite des Sockels (S) angeordnet sind und daß der mindestens eine Magnet (M) den Sockel (S) gegen die Fläche (F) drückt, so daß in einer ersten Stellung die Kontakte (K) mit verschiedenen Anschlüssen der Spannungsquelle (SP) verbundene Leiterbahnen (L) berühren, um dem Verbraucher (G) elektrische Energie zuzuführen, und in einer zweiten Stellung die Kontakte (K) die verschiedenen Leiterbahnen (L) nicht berühren.

2. Elektrische Einrichtung nach Anspruch 1, dadurch gekennzeichnet, daß an dem Sockel (S) mindestens zwei Magnete (M1,M2) vorgesehen sind, die gleichzeitig als elektrische Kontakte (K) verwendet werden.

3. Elektrische Einrichtung nach Anspruch 1, dadurch gekennzeichnet, daß vier Magnete (M1 bis M4) vorgesehen sind, wovon zwei Magnete (M1, M2) gleichzeitig als Kontakte (K) ausgebildet sind und zwei Magnete (M3, M4) isoliert angeordnet sind.

4. Elektrische Einrichtung nach einem der Ansprüche 1 bis 3, dadurch gekennzeichnet, daß die Leiterbahnen (L) streifenförmig ausgebildet sind.

5. Elektrische Einrichtung nach einem der Ansprüche 1 bis 4, dadurch gekennzeichnet, daß die Leiterbahnen (L) in einer Isolierschicht (I) eingebettet sind.

6. Elektrische Einrichtung nach einem der Ansprüche 1 bis 5, dadurch gekennzeichnet, daß die Leiterbahnen (L) ferromagnetisches Material enthalten.

7. Elektrische Einrichtung nach einem der Ansprüche 1 bis 6, dadurch gekennzeichnet, daß in Kontakt mit Leiterbahnen (L) aus ferromagnetischem Material weitere Leiterbahnen (L1) aus nicht-ferromagnetischem Material angeordnet sind.

8. Elektrische Einrichtung nach einem der Ansprüche 1 bis 7, dadurch gekennzeichnet, daß die Fläche (F) mindestens eine ferromagnetische Schicht (FS) aufweist, die von den Leiterbahnen (L) durch eine Isolierschicht (I) getrennt ist.

9. Elektrische Einrichtung nach einem der Ansprüche 1 bis 8, dadurch gekennzeichnet, daß auf einer Isolierschicht (I) die Leiterbahnen (L) angeordnet sind und daß parallel zu den Leiterbahnen (L) und isoliert davon ferromagnetische Schichten (FS) angeordnet sind.

-12-

10. Elektrische Einrichtung nach einem der Ansprüche 1 bis 9, dadurch gekennzeichnet, daß die Fläche (F) als Platte oder Folie ausgebildet ist.

Fig.1

Fig.2

0238017

0238017

Fig. 3

Fig. 4

Fig. 5

Fig. 6

Fig. 7

Fig. 8